# EUROPÄISCHE PATENTSCHRIFT

(11) **EP 0 862 543 B1**
(45) Veröffentlichungstag und Bekanntmachung des Hinweises auf die Patenterteilung: **05.09.2001**
(21) Anmeldenummer: 96945884.3
(22) Anmeldetag: 13.11.1996
(51) Int. Cl.: C04B 41/52

(54) **SCHNEIDWERKZEUG, VERFAHREN ZUR BESCHICHTUNG EINES SCHNEIDWERKZEUGES UND VERWENDUNG DES SCHNEIDWERKZEUGES**
CUTTING TOOL, PROCESS FOR COATING A CUTTING TOOL, AND USE THEREOF
OUTIL DE COUPE, PROCEDE DE REVETEMENT D'UN OUTIL DE COUPE ET UTILISATION DUDIT OUTIL DE COUPE

(30) Priorität: 24.11.1995 DE 19543748
(43) Veröffentlichungstag der Anmeldung: 09.09.1998
(73) Patentinhaber: Widia GmbH, 45145 Essen (DE)
(72) Erfinder: KÖNIG, Udo, D-45149 Essen (DE); TABERSKY, Ralf, D-46240 Bottrop (DE); WESTPHAL, Hartmut, D-36466 Dermbach (DE)
(74) Vertreter: Vomberg, Friedhelm, Dipl.-Phys.
(86) Internationale Anmeldenummer: DE9602188
(87) Internationale Veröffentlichungsnummer: WO9719778

(56) Entgegenhaltungen:
- DE-C- 3 841 731
- DE-C- 4 108 367
- PATENT ABSTRACTS OF JAPAN vol. 007, no. 019 (C-147), 25.Januar 1983 & JP 57 174453 A (SUMITOMO DENKI KOGYO KK), 27.Oktober 1982, & DATABASE WPI Section Ch, Week 8249 Derwent Publications Ltd., London, GB; Class M13, AN 82-05281J
- CHEMICAL ABSTRACTS, vol. 117, no. 2, 13.Juli 1992 Columbus, Ohio, US; abstract no. 13302j, XP000375706 & JP 04 045 258 A (MITSUBISHI HEAVY INDUSTRIES LTD) 14.Februar 1992
- THIN SOLID FILMS, Bd. 245, Nr. 1/02, 1.Juni 1994, Seiten 50-54, XP000453811 JAEGER S ET AL: "INFRARED SPECTROCOPIC INVESTIGATIONS ON H-BN AND MIXED H/C-BN THIN FILMS"

## Beschreibung

Die Erfindung betrifft ein Schneidwerkzeug, insbesondere für die spanabhebende Bearbeitung, bestehend aus einem Hartmetall-, Keramik- oder Cermet-Substratkörper, der mit einer Oberflächenbeschichtung überzogen ist. Die Erfindung betrifft ferner ein Verfahren zur Beschichtung dieses Schneidwerkzeuges sowie die Verwendung dieses Schneidwerkzeuges.

Neben den unbeschichteten Schneidwerkzeugen aus Hartmetallen, Cermets oder Keramiken haben beschichtete Schneideinsätze in der Metallbearbeitung eine große Bedeutung erlangt. Bekannt sind beispielsweise Formkörper, die aus einer zumeist aus den Carbiden des Wolframs, Titans, Niobs und des Tantals sowie metallischem Cobalt als Binder bestehen, worauf durch CVD-, PVD- oder Plasma-CVD-Verfahren aufgebrachte ein- oder mehrlagige Oberflächenschichten angeordnet sind. Diese können beispielsweise aus harten Carbiden, Nitriden oder Carbonitriden der Elemente Titan, Zirkon oder Hafnium oder auch aus Aluminiumoxid bestehen. Insbesondere sind auch mehrlagige Schichten mit einer Schichtfolge TiC, Ti(C,N) und TiN, ggf. mit einer äußeren Al₂O₃-Schicht bekannt. Mit solchen beschichteten Schneidwerkzeugen lassen sich hohe Zerspanungsleistungen und große Standzeiten erreichen, wenn beim betreffenden Drehen, Fräsen oder Bohren des Werkstückes durch Aufgabe einer Schmierstoffflüssigkeit für entsprechende Kühlung gesorgt wird. Als Kühlschmiermittelflüssigkeiten werden hauptsächlich wassergemischte Emulsionen verwendet, deren Hauptbestandteil, nämlich Wasser zu 95 %, für die notwendige Kühlung der Schneide sorgt. Die emulgierten oder gelösten Additive werden benötigt, um beim Zerspanen für die notwendige Schmierung zu sorgen, Korrosionen zu verhindern und um das Werkstück gegen chemische Angriffe zu konservieren. Nachteilig ist die Umweltunverträglichkeit der genannten Additive. Zwar ist es in der Vergangenheit gelungen, toxische Zusatzstoffe, wie Chlorparaffin oder Benzotriazole durch weniger umweltbelastende Substanzen zu ersetzen, gleichwohl verursachen die umweltgerechte Wiederaufbereitung oder Entsorgung der verwendbaren Kühlschmiermittel sowie die Notwendigkeit, die entstandenen Späne zu waschen, nicht unerhebliche Kosten, die unter Umständen den sich aus den hohen Zerspanungsleistungen und den höheren Standzeiten eingesparten Kosten für die Werkzeuge nicht aufwiegen können. Aus wirtschaftlichen Gesichtspunkten ist es zuweilen günstiger, ohne Kühlschmiermittel im Trockenschnitt zu arbeiten und hierbei einen höheren Werkzeugverschleiß in Kauf zu nehmen. Dies wird beispielsweise bei kurzspanenden Werkstückstoffen, wie Gußstählen, schon weitgehend praktiziert. Bei lang spanenden Stählen schmiegt sich der ablaufende Span in einem größeren Bereich an den Schneidkeil des Schneidwerkzeuges an, wobei durch Reibung erhebliche Wärmemengen entstehen. Eine nach dem Stand der Technik bekannte Lösung zielt darauf ab, reibungsarme Beschichtungen der Schneidwerkzeuge, beispielsweise aus Aluminiumoxid, zu verwenden und hiermit den Schneidwerkzeugverschleiß zu minimieren. Diese Maßnahme reicht jedoch im allgemeinen nicht aus, wenn ohne Kühlschmiermittel gearbeitet werden soll.

In der EP 0 534 905 B1 wird vorgeschlagen, Werkzeuge mit "weichen" Schichten aus Chalcogenidverbindungen, wie Molybdändisulfid oder Molybdändiselenid, zu versehen. Solche Schichten können jedoch nur mittels eines kostenaufwendigen PVD-Verfahrens hergestellt werden und erhöhen wegen ihres geringen Abrasionswiderstandes die Schneidwerkzeugstandzeit bei der Stahlbearbeitung nur marginal.

Hiervon ausgehend ist es Aufgabe der vorliegenden Erfindung, ein oberflächenbeschichtetes Schneidwerkzeug anzugeben, das auch ohne Einsatz von Kühlschmiermitteln zufriedenstellende Zerspanungsleistungen und Standzeiten liefert.

Überraschenderweise wurde gefunden, daß dünne Oberflächenschichten aus hexagonalem und amorphem Bornitrid die Standzeit von Schneideinsätzen im Trockenschnitt erheblich verbessern können.

Das erfindungsgemäße Schneidwerkzeug wird im Anspruch 1 beschrieben.

Bornitrid kann in mehreren Modifikationen vorkommen. Eine dieser Modifikationen ist das kubische Bornitrid (CBN) oder das polykristalline kubische Bornitrid (PCB). CBN besitzt eine Kristallstruktur, die eine sehr hohe Härte aufweist (Vickers-Härte 4000 bis 6000). Diese kubische Modifikation entspricht derjenigen, die von Diamanten bekannt ist und entsteht, wenn Bornitrid unter hohen Temperaturen (1500°C bis 1700°C) und hohem Druck (5 x 10¹⁰ Pa (ähnlich wie zur Herstellung von künstlichen Diamanten)) verpreßt wird. Wie in der WO 93/04015 bereits ausgeführt wird, ist es nicht nur seit langem bekannt, Monoblocks aus PCBN als Werkzeugmaterial selbst oder als Inlay, der auf einem Werkzeugträger aufgelötet wird, zu verwenden, sondern auch CBN als Oberflächenschicht auf einen Schneidwerkzeugsubstratkörper aufzutragen. Der Nachteil der aus PCBN bestehenden Werkzeuge liegt darin, daß insbesondere bei der Fertigbearbeitung von Werkstücken aus harten Eisenwerk-stoffen, also bei kleineren Spanungsquerschnitten, ein erheblicher Schneidenverschleiß auftritt, so daß Maß-, Form- und Oberflächenendqualitäten nicht eingehalten werden können. Dieser nachteilige Effekt ist vor allem auf die hohe Wärmeleitfähigkeit der aus PCBN oder CBN bestehenden Werkzeuge zurückzuführen.

Aus JP 61-41768 A ist es zudem bekannt, unter Vermeidung einer geschlossenen Schicht einzelne kubische Bornitrid-Kristalle auf einem Hartmetallegierungs-, einem Cermet- oder einem Keramik-Substrat in einer Höhe von 0,1 bis 10 µm abzuscheiden und die Bornitrid-freien Zwischenräume mit Carbiden, Nitriden, Carbonitriden, Boriden, Bornitriden, Oxiden und Oxicarbiden der IVa- bis VIa-Elemente, hexagonalem BN, amorphem BN und Al₂O₃ aufzufüllen. Die erzielbaren Schneidleistungen waren jedoch unbefriedigend, insbesondere dann, wenn durch unterschiedliche Wärmeausdehnungskoeffizienten der Beschichtungsmaterialien, wie beispielsweise Bornitrid und Al₂O₃, thermische Spannungen beim Abkühlen auftreten, die zu Rißbildungen führen können. Die kubischen Bornitridteilchen dieser Oberflächenschicht neigen unter Beanspruchung auch zum Ausbrechen. Zur Abhilfe wird daher in der WO 93/04015 ein Werkzeug mit einer Oberflächenschicht aus CBN oder PCBN vorgeschlagen, auf der eine dünne Schicht aus einem oder mehreren Metalloxiden aufgetragen worden ist, die beispielsweise aus mindestens einem Oxid der Metalle Magnesium, Yttrium, Titan, Zirkonium oder Aluminium besteht.

Die JP-57-174453 offenbart ein Werkzeug aus einem Substratkörper mit einer Beschichtung aus hexagonalem oder amorphem Bornitrid.

Aus Chemical Abstracts, 117 (1992), Juli 3, Nr. 2, Abstract Nr. 13302j ist eine Schneidwerkzeug-Beschichtung bekannt, bei der TiN-beschichtete Hartmetallwerkzeuge zunächst mit einer Schicht aus kubischem BN und dann mit einer Schicht aus hexagonalem BN überzogen werden.

Demgegenüber besteht die äußere Oberflächenschicht des erfindungsgemäßen Schneidwerkzeuges aus hexagonalem und amorphem Bornitrid. Hexagonales Bornitrid besitzt eine dem Graphit ähnliche Schichtenstruktur mit einem hochpolymeren Molekül-Verbund, der sich aus wabenförmig vernetzten, kovalenten dreiwertigen Bor- und Stickstoffatomen aufbaut. Trotz der deutlich geringeren Härte des hexagonalen Bornitrides konnten mit einer Bornitrid-Außenlage, die hexagonale und amorphe Strukturen besitzt, im Trockenschnitt erheblich bessere Schneidleistungen und Standzeiten erreicht werden. Vorteilhaft wirkt sich hierbei die Reaktionsträgheit des hexagonalen und des amorphen Bornitrids aus.

Weiterbildungen des erfindungsgemäßen Schneidwerkzeuges sind in den Unteransprüchen 2 bis 5 beschrieben.

Die äußere Oberflächenschicht aus hexagonalem und amorphem Bornitrid kann entweder unmittelbar auf einen Hartmetall-, Cermet- oder Keramik-Grundkörper oder auf mindestens eine auf diesem Grundkörper aufgetragene Hartstoffschicht aus Carbiden, Nitriden oder Carbonitriden mindestens eines der Elemente Titan, Zirkon oder Hafnium oder Aluminiumoxid aufgetragen werden. Die Dicke der äußeren Bornitridschicht liegt zwischen 1 µm und 5 µm, vorzugsweise zwischen 1 µm bis 3 µm. Bei mehrlagigen Oberflächenbeschichtungen, wovon die letzte äußere Lage aus hexagonalem und/oder amorphem Bornitrid besteht, soll die Gesamtdicke der Beschichtung 20 µm nicht übersteigen.

Vorzugsweise bestehen mindestens 20 Vol.-% der äußeren Bornitridschicht aus hexagonalem Bornitrid. Die Bornitridschicht ist derart beschaffen, daß das Infrarotspektrum Absorptionslinien bei den Wellenzahlen 800 und 1400 cm⁻¹ aufweist.

Als Substratkörper, auf den die hexagonale und amorphe Bornitridschicht unmittelbar oder unter Zwischenlage weitere Hartstoffschichten aufgetragen wird, wird vorzugsweise ein Hartmetall aus Carbiden des Wolframs, Titans, Niobs und/oder Tantals und einem Cobalt-Binder oder ein Cermet auf Titancarbonitrid-Basis verwendet.

Wendet man zur Abscheidung des hexagonalen und amorphen Bornitrids das CVD-Verfahren an, so sind unter Einsatz des gasförmigen Bortrichlorids als Spendermedium für Bor hohe Temperaturen von mehr als 1200°C notwendig, um ausreichende Abscheidungsraten zu erhalten. Bevorzugt wird daher nach dem in Anspruch 6 beschriebenen Verfahren gearbeitet, das bei Temperaturen zwischen 400°C und 900°C anwendbar ist und bei dem es überraschenderweise gelingt, gut haftende, dichte Bornitridschichten abzuscheiden. Das abgeschiedene Gefüge ist feinkristallin und enthält amorphe Anteile, was durch Röntgenbeugungsuntersuchungen und elektronenmikroskopisch feststellbar ist. Die Härte der abgeschiedenen Schichten ist überraschend gegenüber der Härte des hexagonalen Bornitrids, soweit es durch CVD-Verfahren bei hohen Temperaturen abgeschieden wurde, erheblich größer, nämlich ca. 800 bis 1000 Vickers-Härte gegenüber 200 Vickers-Härte. Der Gleitreibungskoeffizient der Bornitridoberfläche ist gering. Die Anwendung des Beschichtungsverfahrens mittels einer plasmaaktivierten CVD-Atmosphäre wird in der Weise vorgenommen, daß als Spendermedien Bortrichlorid, Stickstoff, Wasserstoff und Argon bei Temperaturen, die vorzugsweise zwischen 500°C und 800°C liegen, und unter Drücken zwischen 100 Pa und 1000 Pa über einen Substratkörper bzw. einen bereits beschichtete Substratkörper geleitet werden. Bevorzugt wird ein Verfahren verwendet, bei dem die Plasmaaktivierung an dem als Kathode geschalteten Werkzeuggrundkörper durch ein gepulste Gleichspannung mit einer in den Pulspausen verbleibenden Restgleichspannung einer Größe, die gleich oder größer als das niedrigste Ionisierungspotential der beteiligten Gase des CVD-Prozeßes ist, maximal jedoch 50 % des maximalen Wertes der gepulsten Gleichspannung ist, durchgeführt. Dieses Verfahren ist im Detail in der DE 38 41 731 C1 oder der EP 0 373 412 B1 beschrieben, worauf Bezug genommen wird.

Besondere Vorteile ergeben sich bei der Verwendung des beschriebenen Schneidwerkzeuges beim Zerspanen von Metallen ohne Zuhilfenahme eines Kühlschmiermittels, d.h., im Trockenschnitt.

Die Erfindung wird im folgenden anhand von Ausführungsbeispielen erläutert.

Zunächst werden handelsübliche, mit einer Mehrlagenschicht aus Titannitrid, Titancarbonitrid und Aluminiumoxid beschichtete Wendeschneidplatten des Typs DNMG 150612-15 ausgewählt. Die Gesamtdicke der Oberflächenbeschichtung schwankte bei den einzelnen verwendeten Platten zwischen 8 bis 10 µm. Mit diesen Schneidplatten werden Getriebewellen mit einem maximalen Durchmesser von 35 mm und einer Länge von 362 mm aus einem Stahlwerkstoff CF 53 V auf einer automatischen Drehmaschine bearbeitet. Die Schnittiefe beträgt 2,5 mm bei einem Vorschub von 0,4, mm/Umdrehung und einer maximalen Schnittgeschwindigkeit von 200 m/min. Unter Anwendung eines Kühlschmiermittels können 33 Teile mit einer Schneidecke des Schneidwerkzeuges hergestellt werden. Ohne Aufgabe eines Kühlschmierstoffes können nur 8 Werkstücke gefertigt werden.

In einem zweiten Versuch werden Wendeschneidplatten der vorgenannten Art ausgewählt, deren Schichtdicken an der unteren Toleranzgrenze lagen. Diese Wendeschneidplatten wurden mittels des Plasma-Puls-CVD-Verfahrens bei einer Temperatur von 709°C und unter einem Druck von 280 Pa beschichtet, wozu ein Gasgemisch mit den folgenden Volumenanteilen verwendet wird: 0,5 % Bortrichlorid, 4,5 % Stickstoff, 65 % Wasserstoff und 30 % Argon. Nach einer Reaktionszeit von 140 Minuten werden fest haftende Bornitridschichten hexagonaler und amorpher Konfiguration in einer etwa 2 µm großen Dicke erhalten. Diese Wendeschneidplatten werden in gleicher Weise wie zuvor beschrieben, ohne Aufgabe von Kühlschmiermitteln, d.h. im Trockenschnitt eingesetzt. In vier aufeinanderfolgenden Versuchen werden mit jeweils einer Schneidecke des Schneidwerkzeuges 25, 27, 24 und 25 Teile gefertigt.

Die vorstehenden Ergebnisse zeigen, daß zwar erwartungsgemäß nicht die Standzeiten bzw. Leistungen erreichbar sind, wie dies unter Anwendung eines Kühlschmierstoffes der Fall ist, jedoch können im Trockenschnitt mit dem erfindungsgemäßen Schneidwerkzeug erhebliche Standzeitverbesserungen bewirkt werden. Berücksichtigt man, daß beim Einsatz erfindungsgemäßer Schneidwerkzeuge die aufwendige Handhabung und Entsorgung des Kühlschmiermittels entfallen kann, ergibt sich insbesondere unter dem Gesichtspunkt des Umweltschutzes und des Arbeitsschutzes ein erheblicher technischer und wirtschaftlicher Fortschritt.

## Patentansprüche

1. Schneidwerkzeug, insbesondere für die spanabhebende Bearbeitung, bestehend aus einem Hartmetall-, Cermet- oder Keramik-Substratkörper, der mit einer Oberflächenbeschichtung aus Bornitrid überzogen ist,
**dadurch gekennzeichnet,**
daß die Oberflächenschicht oder die äußere Oberflächenschicht aus hexagonalem und amorphem Bornitrid besteht.

2. Schneidwerkzeug nach Anspruch 1, gekennzeichnet, durch eine mehrlagige Oberflächenbeschichtung aus Carbiden, Nitriden oder Carbonitriden mindestens eines der Elemente Titan, Zirkonium oder Hafnium oder Aluminiumoxid, worauf als äußerste Schicht hexagonales und amorphes Bornitrid aufgetragen ist.

3. Schneidwerkzeug nach einem der Ansprüche 1 oder 2, **dadurch gekennzeichnet**, daß die Dicke der äußeren Bornitridschicht zwischen 1 um und 5 µm, vorzugsweise zwischen 1 um bis 3 µm, liegt und/oder bei mehrlagiger Oberflächenbeschichtung die Gesamtdicke der Beschichtung 20 µm nicht übersteigt.

4. Schneidwerkzeug nach einem der Ansprüche 1 bis 3, **dadurch gekennzeichnet**, daß mindestens 20 Vol.-% der äußersten Bornitridschicht aus hexagonalem Bornitrid besteht und/oder daß das Infrarotspektrum der äußersten Bornitridschicht Absorptionslinien bei den Wellenzahlen 800 und 1400 cm⁻¹ aufweist.

5. Schneidwerkzeug nach einem der Ansprüche 1 bis 4, **dadurch gekennzeichnet**, daß der Substratkörper aus Carbiden des Wolframs, Titans, Niobs und/oder Tantals und einem Cobalt-Binder oder aus einem Cermet auf Titancarbonitrid-Basis besteht.

6. Verfahren zur Beschichtung eines oder mehrerer Schneidwerkzeuge nach einem der Ansprüche 1 bis 5 mit einer äußersten Schicht aus hexagonalem und amorphem Bornitrid mittels eines plasmaaktivierten CVD-Verfahrens unter Einleitung eines Gasgemisches aus Bortrichlorid, Stickstoff, Wasserstoff und Argon bei Temperaturen zwischen 400°C und 900°C unter Drücken zwischen 100 Pa und 1000 Pa.

7. Verfahren nach Anspruch 6, **dadurch gekennzeichnet**, daß die Plasmaaktivierung an dem als Kathode geschalteten Werkzeuggrundkörper durch eine gepulste Gleichspannung mit einer in den Pulspausen verbleibenden Restgleichspannung einer Größe, die gleich oder größer als das niedrigste Ionisierungspotential der beteiligten Gase des CVD-Prozesses ist, maximal jedoch 50 % des maximalen Wertes der gepulsten Gleichspannung ist, durchgeführt wird.

8. Verwendung eines Schneidwerkzeuges nach einem der Ansprüche 1 bis 5 zum Zerspanen von Metallen ohne Kühlschmierstoffe, nämlich im Trockenschnitt.

## Claims

1. Cutting tool, especially for chip removal machining comprised of hard metal, cermet or ceramic substrate body, coated with a surface coating consisting of boron nitride,
**characterized in that**
the surface coating or the outer surface coating is composed of hexagonal and amorphous boron nitride.

2. Cutting tool according to claim 1, characterized by a multilayer surface coating of carbides, nitrides or carbonitrides of at least one of the elements titanium, zirconium or hafnium, or aluminum oxide, the outermost layer being deposited from hexagonal and amorphous boron nitride.

3. Cutting tool according to one of claims 1 or 2, **characterized in that** the thickness of the outer boron nitride layer is between 1 and 5 *µ*m, preferably between 1 *µ*m to 3 *µ*m and/or in the case of multilayer surface coatings the total thickness of the coating does not exceed 20 *µ*m.

4. Cutting tool according to one of claims 1 to 3, **characterized in that** at least 20 volume % of the outermost boron nitride layer is comprised of hexagonal boron nitride and/or that the infrared spectrum of the outermost boron nitride layer has absorption lines at wavelengths of 800 to 1400 cm⁻¹.

5. Cutting tool according to one of claims 1 to 4, **characterized in that** the substrate body is comprised of carbides of tungsten, titanium, niobium and/or tantalum and a cobalt binder or is constituted of a cermet of a titanium carbonitride basis.

6. Process for coating one or more cutting tools according to one of the claims 1 to 5 with an outermost layer of hexagonal and amorphous boronitride by means of a plasma-activated CVD process with feed of a gas mixture of boron trichloride, nitrogen, hydrogen and argon at temperatures between 400°C and 900°C under pressures between 100 Pa and 1000 Pa.

7. Process according to claim 6, **characterized in that** the plasma activation of the tool connected as a cathode, is effected by a pulsed direct current with a residual DC voltage of a level which is equal to or greater than the lowest ionization potential of the gases used in the CVD process but a maximum of 50 % of the maximum value of the pulsed direct voltage.

8. Use of a cutting tool according to one of the claims 1 to 5 for machining metals without a cooling lubricant, namely in dry cutting.

## Revendications

1. Outil de coupe, en particulier pour l'usinage par enlèvement de copeaux, se composant d'un corps substrat en métal dur, en cermet ou en céramique, qui est couvert d'un revêtement superficiel en nitrure de bore,
**caractérisé par le fait**
que la couche superficielle ou la couche superficielle extérieure se compose de nitrure de bore hexagonal et amorphe.

2. Outil de coupe selon la revendication 1, caractérisé par un revêtement superficiel à plusieurs couches en carbures, nitrures ou carbonitrures d'au moins un des éléments tels que le titane, le zirconium ou le hafnium ou l'oxyde d'aluminium, sur lequel est appliqué du nitrure de bore hexagonal et amorphe comme couche extrême.

3. Outil de coupe selon l'une des revendications 1 ou 2, caractérisé par le fait que l'épaisseur de la couche extérieure en nitrure de bore est comprise entre 1 µm et 5 µm, de préférence entre 1 µm et 3 µm, et/ou que, dans le cas d'un revêtement superficiel à plusieurs couches, l'épaisseur totale du revêtement ne dépasse pas 20 µm.

4. Outil de coupe selon l'une des revendications 1 à 3, caractérisé par le fait que 20 % volumétrique du moins de la couche extrême en nitrure de bore se compose de nitrure de bore hexagonal, et/ou que le spectre d'absorption infrarouge de la couche extrême en nitrure de bore présente des lignes d'absorption aux nombres d'ondes 800 et 1400 cm⁻¹.

5. Outil de coupe selon l'une des revendications 1 à 4, caractérisé par le fait que le corps substrat se compose de carbures du tungstène, du titane, du niobium et/ou du tantale et d'un liant de cobalt, ou d'un cermet à base de carbonitrure de titane.

6. Procédé pour revêtir un ou plusieurs outils de coupe selon l'une des revendications 1 à 5 d'une couche extrême en nitrure de bore hexagonal et amorphe au moyen d'un procédé CVD activé par plasma, en introduisant un mélange de gaz composé de trichlorure de bore, d'azote, d'hydrogène et d'argon, à des températures comprises entre 400°C et 900°C et à des pressions comprises entre 100 Pa et 1000 Pa.

7. Procédé selon la revendication 6, caractérisé par le fait que l'activation par plasma sur le corps de base d'outil connecté en tant que cathode est effectuée par une tension continue pulsée avec une tension continue résiduelle restant dans les intervalles entre impulsions et ayant une grandeur qui est égale ou supérieure au potentiel d'ionisation le plus faible des gaz participant au processus CVD, mais qui fait au maximum 50 % de la valeur maximale de la tension continue pulsée.

8. Utilisation d'un outil de coupe selon l'une des revendications 1 à 5 pour l'usinage par enlèvement de copeaux de métaux sans réfrigérants lubrifiants, à savoir en coupe sèche.
